## Europäisches Patentamt
## European Patent Office
## Office européen des brevets

(11) Publication number: **0 171 003**
A2

# EUROPEAN PATENT APPLICATION

(21) Application number: **85109416.9**

(22) Date of filing: **26.07.85**

(51) Int. Cl.⁴: **H 01 L 29/08**, H 01 L 29/36

(30) Priority: **27.07.84 JP 155223/84**

(43) Date of publication of application: **12.02.86**
**Bulletin 86/7**

(84) Designated Contracting States: **DE FR GB IT**

(71) Applicant: **HITACHI, LTD., 6, Kanda Surugadai 4-chome Chiyoda-ku, Tokyo 100 (JP)**

(72) Inventor: **Horiuchi, Masatada, 5-13-7, Minamicho Nukui, Koganei-shi Tokyo (JP)**
Inventor: **Natsuaki, Nobuyoshi, 1-11-23, Nangai, Higashiyamato-shi Tokyo (JP)**

(74) Representative: **Strehl, Schübel-Hopf, Schulz, Widenmayerstrasse 17 Postfach 22 03 45, D-8000 München 22 (DE)**

(54) **Field effect transistor with composite drain region.**

(57) In a field effect transistor, a drain region and a source region are constituted by at least a first impurity distributed region (14, 15) and a second impurity distributed region (16, 17). The first impurity distributed region (14, 15) has a maximum impurity concentration at the surface of a semiconductor substrate (1), the second impurity distributed region (16, 17) has a maximum impurity concentration in the semiconductor substrate (1), and at least the second impurity distributed region (16, 17) is formed with a gate electrode edge as an impurity introduced window edge. The semiconductor device has excellent breakdown voltage property, excellent current gain property, and very stable and uniform characteristics.

TITLE MODIFIED
see front page

# SEMICONDUCTOR DEVICE

Background of the Invention

The present invention relates to a semiconductor device, and particularly to a miniaturized MOS-type field effect transistor characterized by a high breakdown voltage, high current gain, and stable and uniform characteristics, and which can be realized while maintaining good production yields.

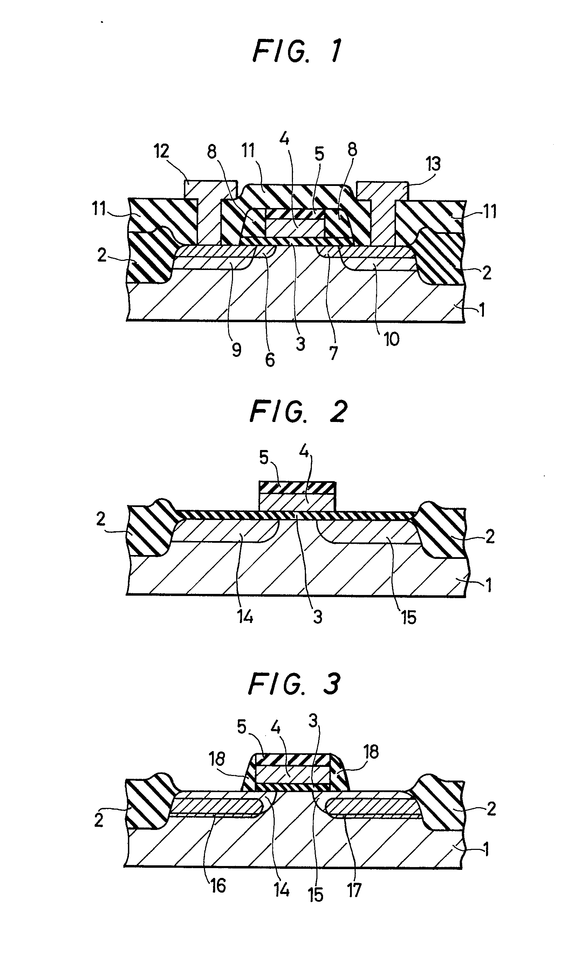

A conventional miniaturized MOS (metal oxide semiconductor) field effect transistor (hereinafter simply referred to as an MOS) which has an effective channel length of less than 1 μm and which operates on a power supply voltage of 5 volts, has a structure such as to provide a high breakdown voltage characteristic as shown in Fig. 1, which is called a lightly doped drain (LDD) structure. A device having this structure has been disclosed in S. OGURA et al: IEEE Trans, Electron Devices, Vol, ED-27, No. 8, p. 1359.

In Fig. 1, reference numeral 1 denotes a p-type silicon substrate, 2 denotes a thick field oxide for isolating elements, 3 denotes a thin gate oxide, 4 denotes a gate electrode, 5 denotes a gate protection insulator, 6 and 7 denote n-type low impurity diffused source and drain regions that are formed by the ion implantation method with the gate electrode 4 as a mask. Reference numeral 8 denotes a gate side wall insulator, and 9 and 10 denote n-type highly concentrated source and drain diffusion regions ($n^+$ regions) that are formed with the gate side wall insulator 8 as a mask. Reference numeral 11 denotes a surface passivation insulator, and 12 and 13 denote source and drain electrodes.

In a miniaturized MOS of the conventional structure shown in Fig. 1, the drain voltage falls off in the lightly doped source and drain diffusion regions ($n^-$-type regions ) 6 and 7. By arbitararily controlling the impurity concentration of the $n^-$-type region or the width thereof (distance from the channel edge of $n^-$-type layer to $n^+$ regions 9, 10), the miniaturized MOS having an effective channel length of shorter than 1 um exhibits a high breakdown voltage without developing avalanche breakdown even against a drain voltage of 5 volts. The $n^+$ fource and drain regions 9 and 10 have a different impurity introduced window edge from that of the $n^-$-type regions 6 and 7. Therefore, the width of $n^-$-type regions increases with the increase in the width of gate side wall insulator 8, and the

breakdown voltage increases in proportion to the gate side wall width. However, there are difficulties that the $n^-$-type regions are not controlled by the gate voltage, since portions of the $n^-$-type regions 6 and 7 of the LDD structure have not been covered by the gate electrode. That is, the $n^-$-type regions 6 and 7 work as series resistors in the LDD structure, and there arise difficulties that the current decreases, i.e., the current gain property decreases if the width of $n^-$-type regions 6 and 7 is increased to improve the breakdown voltage. The above fact negates the effort to realize high-speed operation that is made possible by forming very small semiconductor devices, and the above fact is so grave that the object itself for the miniaturization of the MOS structure is made negative.

Another disadvantage of the conventional LDD structure originates from the fact that the $n^-$-type regions 6 and 7 have an impurity introduced window edge different from that of the $n^+$-type regions 9 and 10. That is, in the LDD construction, the $n^-$-type layers 6 and 7 are formed with the gate electrode 4 as a mask, the gate side wall insulator 8 is formed and, then, the $n^+$-type regions 9 and 10 are formed with the insulator 8 as a mask. In the above manufacturing step, the gate side wall insulator 8 is usually formed by the anisotropical dry etching method which, however, involves a problem with regard to its control property.

0171003

Therefore, the final width of $n^-$-type regions 6 and 7 varies depending upon the fluctuation in the width of gate side wall insulator. The above fluctuation appears in the form of discrepancy in the source to drain breakdown voltage property and in the current gain property, and there arises a disadvantage that the production yields greatly reduce.

Summary of the Invention

The object of the present invention is to provide a miniaturized MOS device which is free from the disadvantages inherent in the above-mentioned conventional art, which exhibits a sufficiently high source to drain breakdown voltage, and which permits a current gain property to decrease by a negligibly small amount. Another object of the present invention is to provide an MOS device of which the properties are little dependent upon the fluctuation in the manufacturing precision, and which has a structure to accomplish a high production yield. A further object of the present invention is to provide an MOS device which is provided with all of the above-mentioned advantages.

In order to achieve the above-mentioned objects, the present invention deals with a field effect transistor in which at least a drain region consists of at least a first impurity distributed region and a second impurity distributed region, the improvement wherein said first impurity distributed region has a maximum impurity concentration in the surface of a semiconductor substrate, said second impurity distributed region has a maximum impurity concentration in the semiconductor substrate, and at least said second impurity distributed region is formed with a gate electrode edge as an impurity introduced window edge.

Owing to the above-mentioned construction, a high breakdown voltage characteristic is obtained, the position of the impurity introduced window edge in the second impurity distributed region is not varied by the fluctuation in the width of gate side wall insulator, and the deviation in the breakdown voltage property decreases strikingly.

Like the above drain region, furthermore, the source region consists of at least a first impurity distributed region and a second impurity distributed region, the first impurity distributed region has a maximum concentration in the surface of the semiconductor substrate, the second impurity distributed region has a maximum concentration in the semiconductor substrate, and at least said second impurity distributed region is formed with a gate electrode edge as an impurity introduced window edge, to obtain more favorable results. Owing to the above-mentioned construction, the current gain characteristics do not deteriorate even though the device is constructed to exhibit a high breakdown voltage, and  fluctuation in the current characteristics or fluctuation in transconductance is greatly decreased.

Usually, the same element will be added as impurities for the first impurity distributed region and for the second impurity distributed region; i.e., phosphorus, arsenic or the like will be added to the n-channel MOS, and boron or the like will be added to the p-channel MOS.

If impurities are introduced by the ion implantation method using the gate electrode as a mask, the first impurity distributed region can be formed by using the same mask as that of the second impurity distributed region, without developing deviation in its characteristics, thereby presenting a great advantage from the standpoint of manufacturing steps.

The first impurity distributed region ranges from 0.1 to 0.3 μm in depth under the surface of the substrate (i.e., the junction depth ranges from 0.1 to 0.3 μm), the impurity concentration is from 1 x $10^{18}$ to 1 x $10^{19}$ $cm^{-3}$ in the surface of the substrate and, more preferably, from 1 x $10^{18}$ to 5 x $10^{18}$ $cm^{-3}$. If the impurity concentration in the surface of the substrate exceeds the above-mentioned range, the breakdown voltage property deteruirates.  If the impurity concentration does not reach the above-mentioned range, on the other hand, the current gain or the transconductance decreases.  In either case, favorable results are not obtained.  In order to improve the current gain property, furthermore, the region which has an impurity concentration of smaller than $1\times10^{18}$ $cm^{-3}$ at the surtace of the semiconductor substrate exists under the gate electrode. The impurity ions that are implanted are concentrated most densely in the interior of the semiconductor substrate. Therefore, the ions which are implanted are diffused by the heat treatment, so that the concentration thereof at the surface will lie within the above-mentioned range, and that the depth of the first impurity distributed region will lie within the above-mentioned range.

The effective channel length is smaller than 1 um like that of the conventional miniaturized MOS.  Length of the gate electrode should be designed beforehand so that a predetermined distance is given by the distance between the first impurity distributed souvce and drain regions or the distance between the second impurity distributed souvce and drain regions after the final fabrication process.

The second impurity distributed region has a maximum impurity concentration that ranges from 5 x

- 8 -

0171003

$10^{17}$ to $5 \times 10^{18}$ cm$^{-3}$ in the semiconductor substrate. Usually, the junction depth of the second impurity distributed region is nearly equal to the junction depth of the first impurity distributed region. The impurity profiles are formed by the ion implantation method using the gate electrode as a mask. Here, the tail of the second impurity profile may reach the surface of the semiconductor substrate or may not reach the surface leaving a small gap relative to the surface. Therefore, the second impurity profile is almost superposed on the first impurity profile, but the edge of the first impurity distributed region on the side of the channel exists without being superposed on the second impurity profile.

The present invention is based on the discovery that the deterionation of current gain property observed in a miniaturized MOS having a high breakdown voltage structure is greatly dependent upon whether a portion having an impurity concentration of smaller than $1 \times 10^{18}$ cm$^{-3}$ in the source and drain diffusion regions is covered by the gate electrode or not, i.e., whether the gate electrode extends onto a portion having an impurity concentration of $1 \times 10^{18}$ cm$^{-3}$ in the source and drain diffusion regions.

That is, in dealing with miniaturized MOS's of an ordinary structure having, for example, an effective channel length of 0.3 µm, and in which the source and drain diffusion layers had an impurity concentration of as high as $1 \times 10^{20}$ cm$^{-3}$ or more in the surface, the source-to-drain currents were measured and compared concerning the case where the gate electrode covered a portion having an impurity concentration of smaller than $1 \times 10^{18}$ cm$^{-3}$ in the source and drain diffusion layers, and the case where the gate electrode covered only a portion having an impurity concentration as low as $1 \times 10^{17}$ cm$^{-3}$ or less in the source and drain regions. In the former case, the current decreased by 1% or less compared with a current value of MOS of an ordinary structure. In the latter case, however, the current decreased by about 5%. In the above experiments, an insulator having an arbitrary thickness was left on the gate side wall and was used as a mask for forming the source and drain diffusion layers.

The invention is further based upon the discovery that the current gain characteristics are not greatly mitigated even if the source and drain diffusion regions do not have an impurity concentration which is as high as $10^{20}$ cm$^{-3}$ or more but have an impurity concentration greater than $1 \times 10^{18}$ cm$^{-3}$, the source

0171003

to drain current path extends relatively deeply in the drain and source diffusion layers and the current gain increases with the increase in the junction depth of the diffusion layers. Based upon the above-mentioned facts, the present invention provides an optimized impurity profile in which low impurity profiles of drain and source are not abruptly graded but are homogeneously maintained even deep in the diffusion layers within a range that does not deteriorate high breakdown voltage property, in order to strikingly increase the current gain          of a miniaturized MOS having the high breakdown voltage structure. In order to realize the above object, the present invention employs the combination of an ion implantation method by which a maximum impurity profile consists in the bulk, and a heat treatment effected at a high temperature for a short period of time or a heat treatment effected at a low temperature for a long period of time to activate impurities while maintaining the impurity profile.

The impurity profile obtained by the ion implantation method tends to assume a lower impurity concentration at the surface of the semiconductor substrate. When the source or drain region is constituted by the above-mentioned impurity profile, therefore, the source or drain resistance increases near the surface of the semiconductor substrate and, in extreme cases, the channel region does not often connect to the source or drain region. In order to avoid the above probability and in order that the resistance will not increase at the surface of the source and drain regions, according to the present invention, a low impurity concentrated region is separately formed, i.e., the first impurity distribution region is separately formed, so that the impurity concentration is maintained to be higher than $10^{18}$ cm$^{-3}$ at the surface.

The source and drain electrodes may be connected by any method to the source and drain diffusion regions, provided good electrical connection is maintained.

Brief Description of the Drawings

Fig. 1 is a section view showing a conventional MOS-type field effect transistor having the LDD structure;

Figs. 2 to 4 are section views showing steps for manufacturing a semiconductor device according to an embodiment of the present invention;

Figs. 5 and 6 are section views showing steps for manufacturing a semiconductor device according to another embodiment of the present invention; and

Fig. 7 is a graph showing relations between the

0171003

transconductance and the source-to-drain breakdown voltage of the MOS-type field effect transistor of another embodiment of the present invention and of the conventional MOS-type field effect transistor.

Description of the Preferred Embodiments

The invention will be described below in further detail by way of embodiments. Some portions of the drawings have been disproportionately enlarged for clarity.

Embodiment 1

Figs. 2 to 4 are section views showing steps for manufacturing a semiconductor device according to this embodiment, wherein reference numeral 1 denotes a silicon substrate having p-type conductivity and resistivity of 1 ohm-cm. As shown in Fig. 2, a field oxide 2 which is as thick as 0.6 μm is selectively formed on the semiconductor substrate 1 utilizing a known element isolation technique, a semiconductor surface of an active region is exposed, and a clean gate oxide 3 which is 10 nm thick is formed thereon. Then, a tungsten (W) film which is about 0.3 μm thick and a gate protection silicon oxide which is 0.2 μm thick and to which phosphorus is added, are deposited on the gate oxide 3. The double-layer film is shaped by the photoetching method thereby to form a W gate electrode 4 and a gate protection oxide 5 which is self-aligned to the gate
electrode.  In the above step of photoetching, other
interconnections can also be formed simultaneously
therewith according to a desired circuit structure.
After the photoetching has been finished, the gate
has a length of 0.5 μm.  Then, using the gate electrode
4 and gate protection oxide 5 as a mask, phosphorus
ions are implanted at an acceleration energy of 30
KeV, followed by heat treatment at 1000°C to activate
and diffuse the implanted ions, so as to form a first
source diffusion layer 14 and a first drain diffusion
layer 15.  The heat treatment is effected for such a
period of time that the junction depth of the first
source and drain diffusion layers is about 0.2 μm.
Further, the ions are implanted under such conditions
that the impurity concentration of the diffusion layers
14 and 15 are maximum at the surface of the semiconductor substrate after the heat treatment has been
effected, and that the impurity concentrations at the
surface lie in a range from $1 \times 10^{18}$ cm$^{-3}$ to $5 \times 10^{18}$
cm$^{-3}$.  These conditions can be set by utilizing a known
technique.

Next, phosphorus ions are implanted for the second
time as shown in Fig. 3 at 90 KeV, followed by the
heat treatment at a temperature as high as 1100°C for

- 14 -

0171003

a period of time as short as 30 seconds to activate the implanted ions, so as to form a second source impurity region 16 and a second drain impurity region 17. Though the heat treatment effected for a short period of time under the above-mentioned conditions, the impurities are diffused very little, but are activated while maintaining the impurity of profiles of the first source diffusion layer 14 and drain diffusion layer 15, and maintaining impurity profile of the ions implanted for the second time. After the heat treatment effected for a short period of time, points of maximum impurity concentration of the second source impurity region 16 and drain impurity region 17 are located at a depth of about 0.1 μm below the surface of the semiconductor substrate. Further, the dosage of phosphorus ions implanted for the second time is so selected that a maximum impurity concentration lies within a range of from $5 \times 10^{17}$ to $5 \times 10^{18}$ $cm^{-3}$. After the above heat treatment effected for a short period of time, a silicon oxide film (PSG film) to which phosphorus is added in small amounts is deposited on the whole surface by the chemical vapor reaction at a temperature of as low as 450°C. The silicon oxide film is deposited to a thickness of 0.2 μm in one experiment, and to a thickness of 0.4 μm in another experiment. Next, the

- 15 -

0171003

deposited oxide film is etched in a direction perpendicular to the surface of the semiconductor substrate by the sputter ion etching (anisotropical etching) to remove the silicon oxide film deposited on flat portions. Through the above etching, the silicon oxide film remains only on the side wall portions of the gate electrode 4 and gate protection insulator 5; i.e., gate side wall insulators 18 are formed. The thickness of the remaining gate side wall insulators 18 is 0.2 μm or 0.4 μm, i.e., equal to the thickness of the film deposited. The gate oxide 3 remaining on the source diffusion layer 14 and drain diffusion layer 15 is etched to some extent by the sputter ion etching. Here, however, the gate oxide film 3 which remains is completely removed with an aqueous solution of hydrofluoric acid (HF), so that the surface of the semiconductor substrate is exposed.

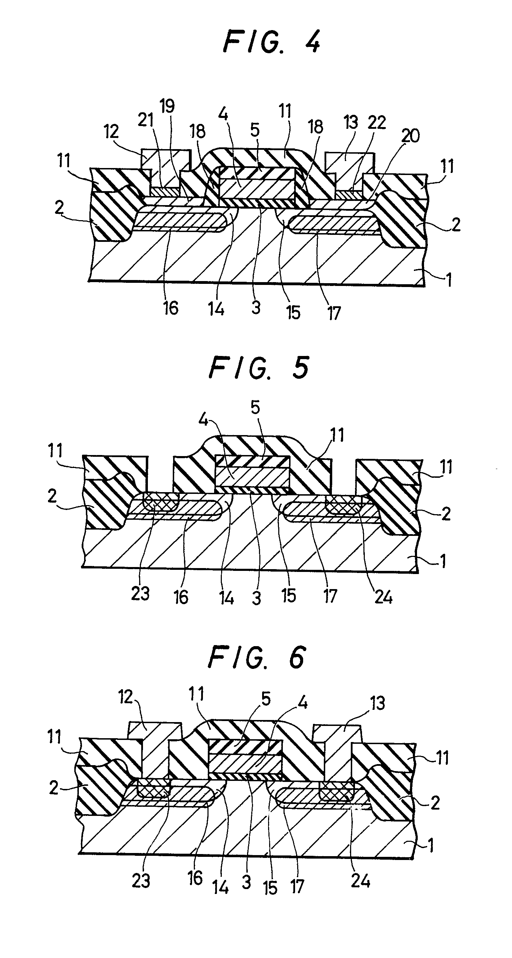

The invention will be described in conjuction with Fig. 4 hereinafter. A titanium (Ti) film is deposited on the whole surface to a thickness of 0.1 μm, and phosphorus ions are implanted under the conditions of a dosage of $5 \times 10^{15}$ cm$^{-2}$ and an acceleration energy of 50 KeV. The phosphorus ions are implanted in order to maintain good ohmic contact with the source and drain regions, as will be mentioned later. Under the above-mentioned conditions, the phosphorus ions are blocked almost completely in the Ti film, and are not implanted into the underlying semiconductor substrate. Then, titanium silicide (hereinafter described as TiSi$_2$, but this composition may not always hold true) layers 19 and 20 are formed on the exposed surface of the semiconductor substrate by the heat treatment effected in a hydrogen atmosphere at 600°C. In the above heat treatment, the Ti film does not react on the gate protection insulator 5, on the gate side wall insulators 18 or on the field oxide 2, and the TiSi$_2$ layer is not formed. Therefore, after the above heat treatment, if the Ti film which has not reacted is removed with a solution consisting of a mixture hydrogen peroxide, water and ammonia aqueous solution, the TiSi$_2$ 'films 19 and 20 that are not etched by the mixture solution, are selectively left (being self-aligned) on the exposed surfaces of the source diffusion layer 14 and drain diffusion layer 15. Phosphorus ions implanted in large amounts into the Ti film segregate at the interface between the silicide films and the semiconductor substrate when the silicide layers are being formed, and enable the source diffusion layer 14 and drain diffusion layer 15 of a low impurity concentration to be brought into good ohmic contact with

the TiSi$_2$ layers 19 and 20. At a heat treatment temperature for forming the silicide layers, phosphorus ions
in the silicon substrate are thermally diffused in
negligibly small amounts. It is therefore presumed
that a layer in which phosphrus ions are segregated
at a high concentration when the silicide layers are
formed, exists having a thickness of 10 to smaller
than 20 nm under the silicide layers. After the silicide
layers 19 and 20 are formed, the silicon oxide film
to which phosphorus     are added in small amounts
is deposited on the whole surface to form a surface
protection insulator 11. Then, windows are formed
by the photoetching method at desired portions in the
surface protection insulator 11 on the silicide layers
19 and 20. Then, as is well known, tungsten (W) and
aluminum (Al) films are evaporated to form electrodes
and wirings inclusive of source electrode 12 and drain
electrode 13 according to a desired circuit structure.
The electrodes 12 and 13 are composed of an Al film.
Here, in order to prevent the reaction between the
Al electrodes and the silicide layers 19, 20, the Al
electrodes are contacted to the silicide layers via
W films 21 and 22 in the window portions in the surface
protection insulator 11.

MOS's with gate side wall insulators 18 having thickness of 0.2 and 0.4 μm manufactured through the above-mentioned steps were measured for their source to drain currents $I_{DS}$ at source and substrate voltages of 0 volt, and at gate and drain voltages of 5 volts. The current was about 5.5 mA irrespective of the gate side wall insulators. In the thus measured MOS's, the effective channel length was 0.3 μm, the drain surface impurity concentration obtained by implanting ions for the first time to form the source and drain diffusion layers was $1 \times 10^{18}$ $cm^{-3}$, and a maximum drain impurity concentration obtained by the second formation of the source and drain regions was about $2 \times 10^{18}$ $cm^{-3}$. The conventional MOS of the LDD structure having the same effective channel length and the same source to drain breakdown voltage property as those of the MOS obtained according to the embodiment of the invention, exhibits an $I_{DS}$ value of a maximum of 5 mA as measured under the same measuring conditions. With the conventional LDD's, furthermore, the $I_{DS}$ value and source to drain breakdown voltage fluctuate by about 10% in the same wafers. When the fluctuation of thickness of the gate side wall insulators is 20%, furthermore, the transconductance and breakdown voltage fluctuate by about 20% with the conventional LDD's, which, however, fluctuate by 2 to not more than 3% with the MOS of the embodiment of the present invention.  Namely, with the MOS's of the embodiment of the present invention, variation in the characteristics is virtually negligible.  According to the embodiment of the invention as will be obvious from the comparison of the aforementioned characteristics, there is obtained a miniaturized MOS of a high breakdown voltage structure which is not affected by variation in the thickness of gate side wall insulators that seriously affect the good properties in the conventional structure, and which exhibits a current value increased by about 10%, i.e., which exhibits a large current gain property, compared with the conventional miniaturized MOS's of the high breakdown voltage structure.

Embodiment 2

The embodiment will be described below in conjunction with Figs. 5 to 7, wherein the same reference numerals as those of Figs. 2 to 4 of the first embodiment denote the same or corresponding portions of the semiconductor device.  By the same manner as in the embodiment 1, as shown in Fig. 5, the ions are implanted for the second time so as to form the second source impurity region 16 and the second drain impurity region (the steps up to this point are the same as those of embodiment 1) having a maximum impurity concentration in the bulk. Then, the surface protection insulator 11 is deposited without effecting the heat treatment at a high temperature for a short period of time, and windows are formed at desired portions. Thereafter, phosphorus ions are implanted for the third time through the windows at a dosage of $5 \times 10^{15}$ $cm^{-2}$ with an acceleration energy of 70 KeV and 30 KeV. After the ions have been implanted for the third time, the heat treatment is effected at a temperature as high as 1100°C for a period of time as short as 30 seconds, to form a high impurity diffused source region 23 and a high impurity diffused drain region 24 corresponding to the ion implantation for the third time. Owing to the heat treatment effected for a short period of time at a high temperature, phosphorus ions implanted for the second and third times are activated without being redistributed. The ions are implanted for the third time under such conditions that a maximum impurity concentration region by the ions implanted for the second time is connected to the surface of the semiconductor substrate through a high impurity concentration region. After the high impurity diffused source region 23 and the high impurity diffused drain region 24 have been formed, the Al film is evaporated and is shaped by photoetching to form electrodes and wiring including source electrode 12 and drain electrode 13 according to a desired circuit construction as shown in Fig. 6.

In the above-mentioned manufacturing steps, the ions were implanted for the first and second times under various conditions to form the source and drain impurity regions. The thus manufactured MOS's were measured for their source to drain breakdown voltage, current $I_{DS}$ and transconductance $g_m$. The source to drain breakdown voltage was measured by maintaining the source, substrate and gate at zero bias, respectively. The current $I_{DS}$ and transconductance $g_m$ were measured by maintaining the source and substrate at zero bias, and maintaining the gate and drain voltages at 5 volts. A source to drain breakdown voltage of about 9 volts and an $I_{DS}$ value of about 5.9 mA were exhibited by the MOS of this embodiment having a surface impurity concentration of $1 \times 10^{18}$ $cm^{-3}$ in the drain diffusion layer 15 as obtained by implanting ions for the first time, having a maximum impurity concentration of $2 \times 10^{18}$ $cm^{-3}$ in the drain impurity region 17 as obtained by implanting ions for the second time, and having an effective channel length of 0.3 µm. The $I_{DS}$ value and breakdown voltage remained nearly constant with negligibly small deviation irrespective of the thickness of the gate side wall insulators. The above results are superior to the properties of the MOS of the aforementioned embodiment 1. It will be comprehended that the $I_{DS}$ value is improved by as much as about 20% compared with the conventional MOS of the LDD structure having the same source-to-drain breakdown voltage and the same effective channel length. In a miniaturized MOS of the high breakdown voltage structure, there is a conflicting relation between the source-to-drain breakdown voltage and the trans-

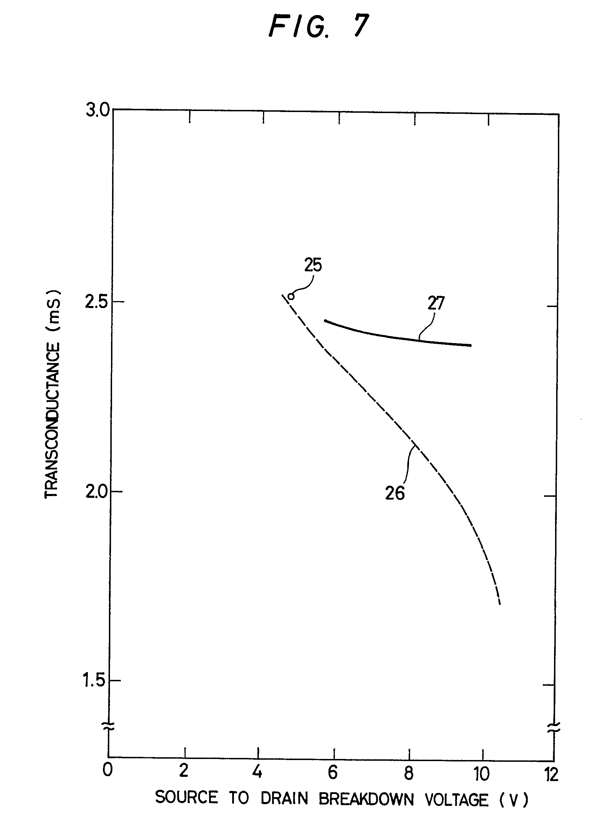

conductance $g_m$. Fig. 7 shows relations between them when the effective channel length is 0.3 μm. Namely,

in Fig. 7, a point 25 represents the case of the MOS of a conventional structure, a curve 26 represents the case of the MOS of a conventional LDD structure, and a curve 27 represents the case of a MOS according to the embodiment of the invention. In other words,

relations between the transconductance $g_m$ and the

source-to-drain breakdown voltage are measured for the MOS's of the aforementioned structures and are shown in Fig. 7. With the MOS of the LDD structure, the source-to-drain breakdown voltage is changed by varying the impurity concentration in the low impurity diffused source and drain layers. With the MOS of this embodiment, the surface impurity concentration in the drain diffusion layer obtained by implanting ions for the first time, is set to $1 \times 10^{18}$ cm$^{-3}$, and a maximum

drain impurity concentration is set to various values by implanting ions for the second time, in order to obtain any desired source-to-drain breakdown voltage. According to this embodiment as will be obvious from Fig. 7, a miniaturized MOS having an effective channel length of 0.3 um exhibits a source to drain breakdown voltage of greater than 9 volts, as well as a high current gain property, permitting the transconductance $g_m$ to be decreased by as little as 4% compared with the MOS of an ordinary structure that exhibits the source-to-drain breakdown voltage of as small as 4.8 volts. With the conventional MOS of the LDD structure which exhibits the source-to-drain breakdown voltage of 9 volts, the transconductance $g_m$ reduced as much as 20% compared with the MOS of an ordinary structure. As shown in Fig. 7, it will be obvious that the MOS of this embodiment exhibits large transconductance and excellent current gain property compared with the MOS of the LDD structure under any breakdown voltage conditions.

According to the present invention as will be obvious from the aforementioned embodiments, the low impurity concentration region is formed using the gate electrode only as a mask to constitute a miniaturized MOS of the high breakdown voltage structure. Therefore, the miniaturized MOS is affected very little by the thickness fluctuation of gate side wall insulators, and exhibits very little fluctuation in characteristics and high breakdown voltage and high current gain property. According to the present invention, furthermore, a relative high impurity concentration can be maintained deep in the low impurity diffused source and drain regions within a range which does not deteriorate high breakdown voltage characteristics. Therefore, the source to drain current path can be utilized more broadly. Compared with the conventional widely-known LDD structure, therefore, the transconductance can be increased by about 20% under the same source to drain breakdown voltage condition. The MOS permits the transconductance to be decreased by as little as 4% compared with the conventional MOS which does not have high breakdown voltage characteristics.

In the first embodiment of the presnet invention,

the $TiSi_2$ layers 19 and 20 are formed on the source and drain diffusion layers 14 and 15. Here, however,

the $TiSi_2$ layers may be replaced by a silicide film of a transition metal or a refractory metal such as platinum, palladium, molybdenum, tungsten, nickel, tantalum, niobium, chrouium, or praseodymium. In the first embodiment of the present invention, tungsten films 21 and 22 are provided between the $TiSi_2$ layer and the aluminum electrode. The tungsten films, however, may not be provided.

In the second embodiment of the present invention, the ions are implanted at a high concentration to connect the surface of the semiconductor substrate to maximum impurity concentration regions in the source and drain -impurity regions formed by implanting ions for the second time. Instead of implanting ions at a high concentration, however, the above connection can be accomplished by forming a silicide film of a refractory metal deeply into the semiconductor substrate by, for example, effecting the heat treatment for an extended period of time.

The aforementioned first and second embodiments have employed a high-temperature furnace to effect the heat treatment at a high temperature for a short period of time. However, the manufacturing steps may be carried out relying upon the heating method by lamp, laser irradiation method, electron-beam irradiation method, or the heat treatment effected for a long period of time at a low temperature.

In the embodiments of the present invention, furthermore, the source and drain regions were formed by implanting phosphorus ions. These regions, however, may be formed by implanting arsenic ions. Further, the above embodiments have dealt with the so-called n-channel MOS obtained by forming source and drain regions of n-type impurities in a semiconductor substrate of p-type conductivity. The invention, however, is in no way limited to the n-channel semiconductor device only but can also be adapted to the so-called p-channel MOS which consists of n-type semiconductor substrate and p-type source and drain regions. When the p-channel MOS is to be obtained, boron ions or the like having p-type of conductivity should be implanted as impurities. It need not be pointed out that the present invention is adapted not only to discrete MOS alone but also to semiconductor integrated circuit devices.

In dealing with the semiconductor device of the present invention, knowledge widely accepted in this field of art may be adapted to those matters that are not described in this specification.

Obviously many modifications and variations of the present invention are possible in the light of the above teachings. It is therefore to be understood that within the scope of the appended claims the invention may be practiced otherwise than as specifically described.

CLAIMS:

1.   A field effect transistor in which at least a drain region is constituted by at least a first impurity distributed region and a second impurity distributed region, characterised in that said first impurity distributed region (15) has a maximum impurity concentration at the surface of a semiconductor substrate (1), said second impurity distributed region (17) has a maximum impurity concentration in said semiconductor substrate (1), and at least said second impurity distributed region (17) is formed with a gate electrode edge as an impurity introduced window edge.

2.   The field effect transistor of claim 1, wherein a source region is also constituted by at least a first impurity distributed region (14) and a second impurity distributed region (16), wherein said first impurity distributed region (14) has a maximum impurity concentration at the surface of said semiconductor substrate (1), said second impurity distributed region (16) has a maximum impurity concentration in said semiconductor substrate (1), and at least said second impurity distributed region (16) is formed with a gate electrode edge as an impurity introduced window edge.

3. The field effect transistor of claim 1 or 2, wherein the impurity concentration at the surface of said semiconductor substrate (1) ranges from $1 \times 10^{18}$ to $1 \times 10^{19}$ $cm^{-3}$, preferably from $1 \times 10^{18}$ to $5 \times 10^{18}$ $cm^{-3}$.

4. The field effect transistor of any of claims 1 to 3, wherein the maximum impurity concentration in the second impurity distributed region (16, 17) ranges from $5 \times 10^{17}$ to $5 \times 10^{18}$ $cm^{-3}$.

5. The field effect transistor of any of claims 1 to 4, wherein a region that has an impurity concentration smaller than $1 \times 10^{18}$ $cm^{-3}$ at the surface of said semiconductor substrate (1) exists under the gate electrode (4).

6. The field effect transistor of any of claims 1 to 5, wherein said first impurity distributed region (14, 15) has a junction depth of 0.1 to 0.3 µm.

7. The field effect transistor of any of claims 1 to 6, wherein the junction depth of said second impurity distributed region (16, 17) is substantially equal to that of said first impurity distributed region (14, 15).

## FIG. 1

## FIG. 2

## FIG. 3

FIG. 4

FIG. 5

FIG. 6

FIG. 7